Europäisches Patentamt

European Patent Office

Office européen des brevets

(11) Publication number: **0 090 059**
**A1**

## EUROPEAN PATENT APPLICATION

(21) Application number: 82102572.3

(51) Int. Cl.³: **H 01 R 23/70**

(22) Date of filing: **26.03.82**

(43) Date of publication of application: **05.10.83**
**Bulletin 83/40**

(84) Designated Contracting States: **DE GB IT SE**

(71) Applicant: **BUNKER RAMO CORPORATION,**
**900 Commerce Drive, Oak Brook Illinois 60521 (US)**

(72) Inventor: **Péchard, Luc, Villa les Bruyères Landon,**
**F-39100 Dole (FR)**
Inventor: **Bouley, Jean-Claude, Villa les Quatre Vents**
**Authume, F-39100 Dole (FR)**
Inventor: **Logerot, Bernard, Santans, F-39380 Mont Sous**
**Vaudrey (FR)**

(74) Representative: **Wagner, Karl H., P.O.**
**Box 246 Gewürzmühlstrasse 5, D-8000 Munich 22 (DE)**

(54) Connector for printed circuit boards for effecting a resilient pressure contact with at least one conductive surface.

(57) The present invention concerns a connector for effecting a resilient pressure contact with a printed circuit board (106).

It comprises a housing (101) provided with connection means (102 and 103), containing a contact constituted by an insulating supple strip (107) carrying, on its outside surface, two series of metal tracks (108 and 109), and a series of spring blades (110 and 111) comprising swellings (119 and 120) intended to apply, on metal tracks (108 and 109), constant pressure. In this way, when the printed circuit board (106) is introduced in passageway (117), the metal tracks (104 and 105) are connected electrically to connection means (102 and 103).

## CONNECTOR FOR PRINTED CIRCUIT BOARDS FOR EFFECTING
## A RESILIENT PRESSURE CONTACT WITH AT LEAST ONE CONDUCTIVE SURFACE

The present invention concerns a connector for printed circuit boards for effecting a resilient pressure contact with at least one conductive surface on at least one face of a rigid structure, said connector comprising :

- a housing having guiding means for directing the rigid structure along a path in an insertion direction,
- and at least a resilient contact located in the housing and having a first end portion initially positioned in said path, and movable along said path, a second end portion integral with a connexion means mounted on said housing, and a central part positioned outside said path,
- said first end portion comprising means for being displaced with said rigid structure moving along said path in said insertion direction, in such a manner to incurve said contact and to create a rolling pressure against the conductive surface on the rigid structure.

French patent application 77/19271 describes a connector of this type, in which the resilient contact has the form of a conductive metal blade, whose resilience creates sufficient pressure, exerted by the rounded part of this blade on the conductive surface of the rigid structure, in order to ensure good electrical contact between the two conductive parts.

However it has been noticed that in practice this contact pressure is too week, because soft coatings, for example tin-lead electrolytic coatings, do not give homogeneous contact resistance. These defects become notably serious when the device is submitted to vibrations. An increase of the thickness of the blades diminishes their flexibility and causes them to break.

The present invention has for its object to avoid the above mentioned inconveniences by making a connector such as that defined previously, in which the contact comprises at least one resilient blade made from electrically good conductive material, and at least a spring component made from material having good elastic properties, the said spring component being adapted to lean against the said resilient blade in order to ensure substantially constant elastic pressure of the said central portion of the resilient blade against the conductive surface.

According to another object of the invention, the contact blade is fixed by one of its ends to the said connexion means. The preferred fixing method is soldering, notably soldering by points effected by laser.

For connecting printed circuit boards provided with a series of parallel conductive tracks, constituting the said rigid structure comprising a series of conductive surfaces, the connector according to the invention comprises preferably a series of contacts, each provided with a resilient blade made from electrically good conductive material, and a spring component, preferably a blade made from material having good elastic properties, the said resilient blades and said spring blades being respectively parallel to each other, each spring blade comprising a resilient blade, these two elements constituting a couple of elements which co-operate to ensure substantially constant elastic pressure and good electrical contact of each resilient blade on the corresponding conductive surface of the rigid structure.

According to still another object of the invention, the connexion means and spring blade are made from one piece. The lower part of this piece constitutes the connexion means which may appear under different known specific forms. The upper part of this piece constitutes the spring blade to which is fixed the contact blade.

In certain cases, notably when the number of couples : connexion means conductive blades is high, the assembly by soldering by laser can be complicated due to difficulties in placing low dimension pieces which are fragile, which stick together and whose handling is thereby extremely delicate.

With the aim of simplifying assembly work, the connector according to another object of the present invention is characterized in that the contact comprises a resilient insulating support in strip form, at least one metal track applied on one face of the said support, the spring means being adapted to lean against the other face of the said insulating support, in such a way as to apply the said central portion of the said contact, with a substantially constant pressure, against the said conductive surface of the said rigid structure.

According to a particularly advantageous embodiment of the present invention, the conductive track comprises an electrically good conductive metal blade, integral with the said support. The conductive track consists preferably of a blade made from a copper material, covered on its free surface, by a protective layer, made for example, out of a tin-lead alloy applied by a known galvanic process.

The insulating support is preferably a sheet of synthetic material, for example, of a polyimide type. The thickness of the insulating support and the conductive blade is such that the whole is extremely resilient and flexible in order that the conductive track leans firmly against the conductive surfaces of the rigid structure.

According to a preferred embodiment of the invention, the connector comprises a series of conductive tracks corresponding respectively to a series of conductive surfaces of the rigid structure, these tracks being placed parallel on a face of the insulating support strip, and a collection of spring blades adapted to apply individually the central portions of the said conductive tracks, with a substantially constant pressure, on the conductive surfaces of the rigid structure. The conductive tracks are preferably connected electrically to the connection means integral with the housing by crimping.

The spring means, which are preferably parallel blades, are preferably attached by their base to a continuous transversal strip in such a way that a comb structure is obtained. The upper free ends of these blades comprise a swelling intended to lean against the central portions of the conductive tracks of the rigid structure.

When the flat rigid structure comprises conductive tracks on its two opposed flat faces, the spring blades are adapted to form a double comb structure, the blades being placed on two rows parallel to each other and being attached by their base to a continuous transversal strip, which comprises means for fixing this double comb inside the housing, in the extension of the said path in the insertion direction of the rigid structure.

The contact comprises a supple strip portion having, before being mounted in the housing, a form appreciably rectangular, comprising two opposed series of conductive tracks parallel to each other, the strips of one series being separated from those of the other by an insulating zone, this strip being folded in "M" shape to be introduced into the housing, the free ends of the two arms of the M being connected by clamping to corresponding connection means, and the insulating means being placed in the central part of the M, and surrounding the end of the runner which moves along said path during insertion of the rigid structure.

The present invention and its principal advantages will be better understood with reference to the description of a different embodiment therefrom and to the various drawings on which :

Figure 1 represents a schematic view of a first embodiment of the connector according to the invention, before introduction of a printed circuit board,

Figure 2 represents the connector of fig. 1 when the printed circuit board is in place,

Figure 3 represents a flat view of a second embodiment of the connector according to the invention, before insertion of the rigid structure,

Figure 4 represents a flat view of the connector according to fig. 3, after insertion of the rigid structure, and

Figure 5 represents a flat view of the insulating support and the metal tracks of the contact.

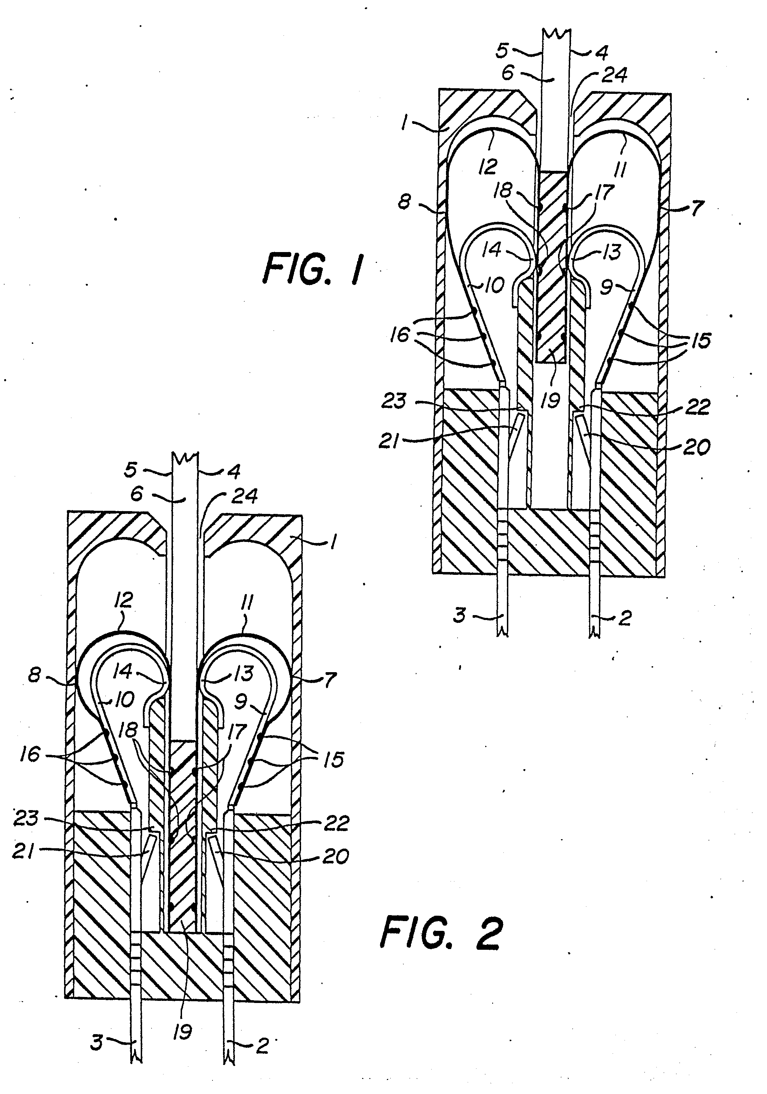

With reference to figures 1 and 2, the connector described includes a housing 1 at the base of which are mounted two series of connexion means 2 and 3, intended to be connected to the conductive tracks 4 and 5 of a printed board 6, by means of contacts which will be described in more detail below.

These contacts are made up essentially of a supple blade 7, respectively 8, and a spring blade 9, respectively 10. The supple blades 7 and 8 are made from an electrically good conductive material such as copper or its alloys, and comprising an outside layer 11, respectively 12, of a protecting material such as a tin-lead alloy. The spring blades 9, respectively 10, comprise a swelling 13, respectively 14, by which they apply a substantially constant pressure on the inside surface of the conductive blade 7, respectively 8. The opposed ends of the spring blades 9 and 10 are respectively connected to the connection means 2 and 3. According to a preferred embodiment, the spring blades and corresponding connection means are made from one piece. The supple conductive blades 7 and 8 are fixed, preferably by soldering by points by laser (see references 15 and 16) to a branch appreciably rectilinear of the corresponding spring blade 9, respectively 10. When the spring blades are not made from one piece with the corresponding connection means, the conductive blade can also be joined to a branch of the corresponding connection means. The other end of the conductive blades 7, respectively 8, is preferably fixed, by any appropriate means, notably by soldering by points by laser (see references 17 and 18), to the lateral walls of a runner 19, capable of adopting two positions represented respectively by figures 1 and 2.

Connection means 2 and 3 comprise respectively an elastic tongue 20 and 21, intended to slide under shoulders 22 and 23 provided in a wall defining the interior cavities of the housing 1. The connection means can be introduced at the top of the housing 1, until these elastic tongues slip under the corresponding shoulders 22 and 23.

When printed circuit board 6 is introduced, runner 19 is pushed down until it is in the stop position against the base of housing 1. During insertion of the printed circuit board in the passageway 24 provided in housing 1 and whose lateral walls serve as guiding means, the conductive blades 7 and 8 are applied without friction against the metal tracks 4 and 5 of printed circuit board 6, under a substantially constant pressure due to resilient pression of the swellings 13 and 14 of the spring blades 9 and 10.

Thanks to this device, is thus solved the problem set by the prior art, by ensuring resilient support with a substantially constant pressure of the conductive blade on the metal tracks of the printed circuit board.

Printed circuit boards 6 comprise in general a series of parallel metal tracks, placed on each of these two flat faces. To ensure contact with these different tracks, the connector comprises a series of couples each made up of a conductive blade 7 (respectively 8) and a spring blade 9 (respectively 10), each one of these couples being respectively associated with connection means 2 and 3. These couples of elements together constitute a double series of contacts which assure electric contact between the double series of connection means and the double series of metal tracks of the printed circuit board.

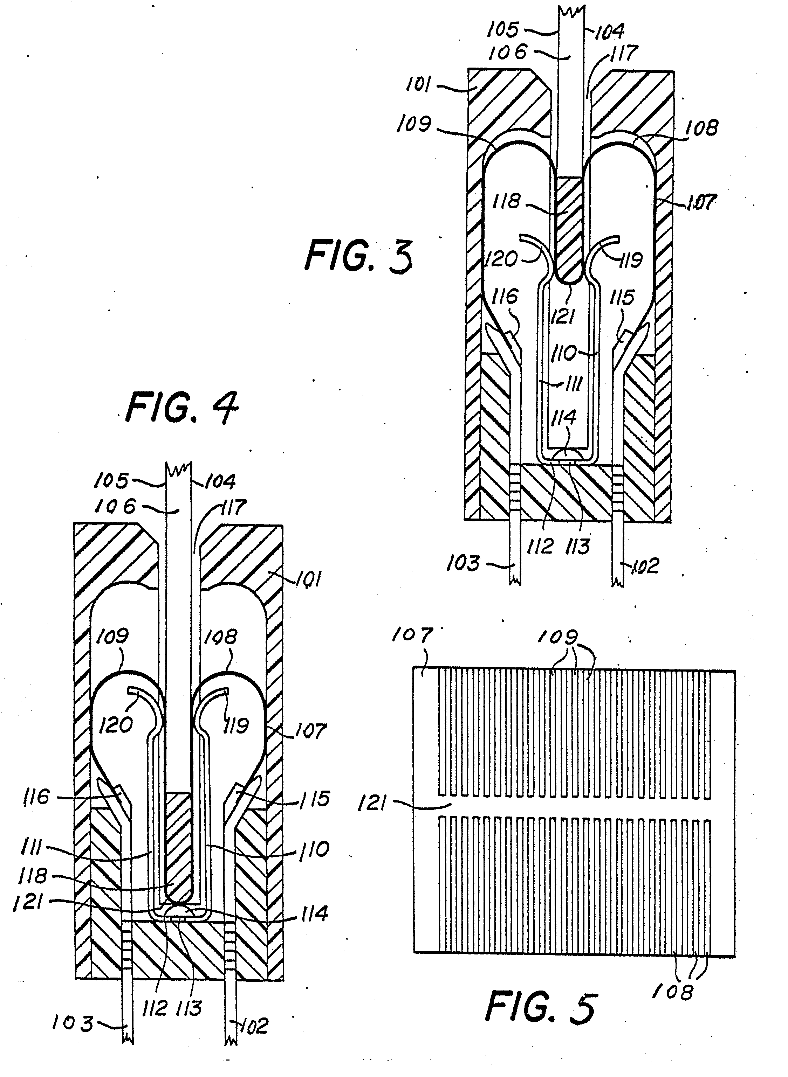

With reference to figures 3 to 5, the connector described represents a housing 101 containing at least one contact adapted for ensuring contact between connection means 102 and 103, and metal tracks 104 and 105 of a flat rigid structure constituted for example of a printed circuit board 106.

The contact is made up, in the present case, of a supple insulating support 107 comprising at least two metal tracks 108 and 109 placed on the exterior surface of the said supple support, and two spring blades 110 and 111 joined to their base by a central transversal strip 112.

In practice, the printed circuit board comprises a series of parallel tracks 104 on one of its faces, and a series of parallel tracks 105 on its opposed flat face. To ensure contact respectively with each of tracks 104 and 105, the supple insulating support 107 comprises a first series of metal tracks 108 parallel to each other and a second series of metal tracks 109, equally parallel to each other and parallel to tracks 108 of the first series. To each track 108 corresponds a spring blade 110 and to each track 109 corresponds a spring blade 111. Each one of these blades is joined by its base to the continuous transversal strip 112, which comprises a series of openings 113 intended to be fixed to the body 101 of the connector, for example by rivets 114. The collection of the spring blades 110 and 111 presents a double comb structure.

If the printed circuit board comprises only one series of metal tracks, the double comb structure could be replaced by a simplified structure, comprising only one series of spring blades 110 or 111.

The upper ends of the connection means 102 and 103 comprise crimping means 115 and 116 already known, comprising crimping means capable of crossing the insulating support 107 and producing electric contact with the corresponding metal track 108 or 109.

The housing 101 comprises, in its centre, a passageway 117, whose lateral walls constitute guiding means which direct the printed circuit board 106 according to a fixed path in its insertion direction into the housing. A runner 118, described in more detail in the above French appln. is permanently introduced in the passageway 117 and moves between a first position (represented by figure 3) and a second position (represented by figure 4). In the first position, the printed circuit board 106 is being inserted in the connector. In the second position, this board is totally inserted in the connector, and contact is established between tracks 104 and 105, respectively with the connection means 102 and 103, through the intermediary of the respective metal tracks 108 and 109.

Thanks to swellings 119 and 120 of the upper ends of the spring blades 110 and 111, metal tracks 108 and 109 are applied, with a substantially constant pressure, against the metal tracks 104 and 105 of the printed circuit board 106. As support 107 of the metal tracks 108 and 109 is insulating, the spring blades 110 and 111 can be joined to each other without risking a short circuit between the metal tracks of the same series (104 or 105) or the two series (104 and 105).

As in the device described in the above mentioned French application, the metal tracks 108 and 109, which constitute the contact blades, roll without friction on the corresponding metal tracks 104 and 105 of the printed circuit board.

Figure 5 represents a flat view of the insulating support 107 comprising, on its outside surface, a first series of metal tracks 108 parallel to each other, and a second series of metal tracks 109 parallel to each other and, in the present case, placed in the extension of the metal tracks 108. The two series of tracks 108 and 109 are separated by a neutral insulating zone 121. The production of metal tracks 108 and 109 is carried out by a photochemical procedure, identical to the techniques used for producing printed circuits. The supple support 121 is preferably made of a synthetic material of the polyimide family.

When placing the insulating support 107 carrying the metal tracks 108 and 109 in the housing 101 of the connector, the supple strip is folded into an "M" shape, in such a way that the neutral zone 121 corresponds to the lower end of the runner 118, and that the respective ends of the metal tracks 108 and 109, opposite the neutral zone 121, correspond to the crimping means 115 and 116 of the connection means 102 and 103.

The metal tracks 108 and 109 are preferably made of copper or copper alloy covered with a layer of protective tin-lead alloy.

Of course different production variants can be foreseen. Notably, metal tracks 108 and 109 can be arranged differently in order to be adapted to an arrangement corresponding to metal tracks 104 and 105 of the printed circuit board 106. Moreover the ends of metal tracks 108 and 109 could be connected by different means from connection means 102 and 103. Nevertheless, the realization such as that described seems to be that which gives the best results for relatively modest manufacturing costs, and relatively easy assembly conditions.

- 9 -                              0090059

Claims

1. Connector for effecting a resilient pressure contact with at least one conductive surface on at least one face of a rigid structure, said connector comprising :
- a housing having guiding means for directing the rigid structure along a path in an insertion direction,
- and at least a resilient contact located in the housing and having a first end portion initially positioned in said path, and movable along said path, a second end portion integral with a connection means mounted on said housing, and a central part positioned outside said path,
- said first end portion comprising means for being displaced with said rigid structure moving along said path in said insertion direction, in such a manner to incurve said contact and to create a rolling pressure against the conductive surface on the rigid structure, characterized in that the contact comprises at least one resilient blade made from electrically good conductive material, and at least a spring component made from material having good elastic properties, the said spring component being adapted to lean against the said resilient blade in order to ensure substantially constant elastic pressure of the said central portion of the resilient blade against the conductive surface.

2. Connector according to claim 1, characterized in that the contact blade is fixed, by one of its ends, to said connection means.

3. Connector according to claim 2, characterized in that the contact blade is fixed to the connection means by soldering.

4. Connector according to claim 3, characterized in that the contact blade is fixed to the connection means by soldering by points effected by laser.

5. Connector according to claim 1, characterized in that the spring means is constituted by a spring blade adapted to lean against the inside surface of the contact blade.

6. Connector according to claim 5, characterized in that it comprises a series of contacts, each one comprising a supple blade made out of material having good resilient properties, the said supple blades and said spring blades being respectively parallel to each other, each spring blade corresponding to a supple blade, these two elements constituting a couple of elements which co-operate to ensure a substantially constant elastic pressure and a good electric contact of each supple blade with the corresponding conductive surface of the rigid structure comprising a series of conductive surfaces, whose number is equal to that of the series of contacts.

7. Connector according to claim 1, characterized in that the spring blade and the connection means are made from one piece.

8. Connector according to claim 1, characterized in that the contact comprises a supple insulating support in strip form, at least one metal track applied on one face of the said support, the spring means being adapted to lean against the other face of the said insulating support, in such a way as to apply the said central portion of the said contact, with a substantially constant pressure, against the said conductive surface of the said rigid structure.

9. Connector according to claim 8, characterized in that the said conductive track comprises an electrically good conductive metal blade, integral with the said support.

10. Connector according to claim 9, characterized in that the said metal blade is covered with a protective coating.

11. Connector according to claim 10, characterized in that the said protective coating is constituted by a layer of tin and lead alloy.

12. Connector according to claim 8, characterized in that the support is constituted by a supple sheet of synthetic material.

13. Connector according to claim 6, characterized in that the support is made from a material of the polyimide type.

14. Connector according to claim 9, characterized in that the metal blade is made from a copper alloy.

15. Connector according to claim 14, characterized in that the metal blade is treated on its free face by a galvanic process.

16. Connector according to one of claims 7 to 15, characterized in that it comprises a series of conductive tracks corresponding respectively to a series of conductive surfaces of the rigid structure, the said tracks being placed parallel on the face of the insulating support strip, and a collection of spring blades adapted for applying the central portions of the said conductive tracks, with a substantially constant pressure, on the corresponding conductive surfaces or the rigid structure.

17. Connector according to claim 16, characterized in that the spring means are constituted by parallel blades and are fixed by their lower end to a continuous transversal strip, these blades together presenting a structure of comb form, the free upper ends of these blades comprising a swelling intended to be leant against the said central portions of the said conductive tracks of the rigid structure.

18. Connector for effecting resilient pressure contact with a series of conductive surfaces placed on the two opposite flat faces of a flat rigid structure according to claim 17, characterized in that the spring blades together present a double-comb structure, each blade being attached by its lower end to a continuous strip comprising means for fixing the said double-comb inside the said housing, in the extension of the said path in the insertion direction of the rigid structure.

19. Connector according to claim 18, caracterized in that the contact comprises a supple strip having , before being mounted in the housing, a substantially rectangular shape, comprising two opposed series of conductive tracks parallel to each other, the strips of one series being separated from those of the other by an insulating zone, this strip being folded in "M" shape in order to be introduced in the housing, the free ends of the two arms of the "M" being connected by crimping to

0090059

corresponding connection means, and the insulating zone being placed in the central part of the "M", and surrounding the end of the runner which moves along the said path during insertion of the rigid structure.

20. Connector according to one of claims 7 to 19, characterized in that the conductive tracks are applied on a face of the said support by a photograve technique.

21. Connector according to one of claims 7 to 20, characterized in that the spring blades are connected to said conductive tracks by crimping, by means of crimping means which pierce the insulating support.

1/2     0090059

FIG. 1

FIG. 2

FIG. 3

FIG. 4

FIG. 5

## EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A,D | FR-A-2 395 676 (USINE MET. DOLOISE) <br> *Page 6, line 13 to page 12, line 4; page 14, line 23 to page 16, line 15; figures 1-6,12-14* & US - A - 4 221 448 | 1 | H 01 R 23/70 |
| A | US-A-4 118 094 (TRW) <br> *Column 2, line 52 to column 7, line 40; figures 1-4* | 1 | |
| A | US-A-3 040 291 (METHODE ELECTRONICS) <br> *Column 1, line 61 to column 3, line 69; figures 1-4* | 1 | |
| A | US-A-3 509 519 (INT. STANDARD EL.) <br> *Column 2, lines 9-71; figures 1-3* | 1 | TECHNICAL FIELDS SEARCHED (Int. Cl. ³) <br><br> H 01 R 23/00 |

The present search report has been drawn up for all claims

| Place of search <br> THE HAGUE | Date of completion of the search <br> 24-11-1982 | Examiner <br> LOMMEL A. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82